# EUROPEAN PATENT APPLICATION

(11) **EP 4 648 102 A1**
(43) Date of publication of application: **12.11.2025**
(21) Application number: 23866629.1
(22) Date of filing: 14.07.2023
(51) Int. Cl.: H01L 23/495

(54) **METAL CLIP ASSEMBLY, AND SEMICONDUCTOR DEVICE ASSEMBLY AND PREPARATION METHOD THEREFOR AND USE THEREOF**

(30) Priority: 06.01.2023 CN 202310015729
(71) Applicant: Chongqing Alpha and Omega Semiconductor Limited, Chongqing 400700 (CN)
(72) Inventor: WANG, Limin, Beibei District Chongqing 400700 (CN); HUANG, Xin, Beibei District Chongqing 400700 (CN)
(74) Representative: Metida
(86) International application number: PCT/CN2023/107361
(87) International publication number: WO 2024/078077

(57) **Abstract**

A metal clip assembly, a semiconductor device assembly, a preparation method therefor, and a use therefor are provided. The metal clip assembly includes metal clip units. The metal clip units include connectors, pins, and at least one group of spatial positioning grooves. By sharing the at least one group of spatial positioning grooves, a spatial structure of the metal clip assembly is simplified, and it facilitates convenient positioning on the metal frame. Positions of the metal clip assemblies are positioned in a horizontal direction through cooperation between X-direction positioning grooves and X-direction positioning pins, and cooperation between Y-direction positioning grooves and Y-direction positioning pins. Further, positions of the metal clip assemblies in a height direction is positioned by configuration of positioning bumps. Through a surface tension of melt solder paste, an automatic alignment of the metal clip assemblies is completed on the metal frame.

## Description

### TECHNICAL FIELD

The present disclosure relates to a technical field of semiconductor pieces manufacturing, and in particular to a metal clip assembly, a semiconductor device assembly, a preparation method of the semiconductor device assembly, and a use of the semiconductor device assembly.

### BACKGROUND

Currently, power semiconductor discrete devices generally complete packaging of internal electrical connection structures by welding metal wires. The metal wires are selected from aluminum wires, copper wires, gold wires, etc. Due to low cost and low process technology difficulty, such wire welding method is widely used in the industry. However, the power semiconductor discrete devices continue to develop towards higher frequencies, higher power density, and higher reliability, the wire welding method is no longer suitable for some high-demand applications.

Therefore, electrical connection technologies that adopt aluminum strips or copper clips to replace the metal wires are well developed and applied. Especially, in the electrical connection technology adopting the copper clips, the metal wires are replaced with wide copper sheets, which allows the power semiconductor discrete devices to have better heat dissipation capabilities, higher current carrying capabilities, lower parasitic parameters, lower on-resistance, and higher reliability.

Generally, soldering of semiconductor chips are realized by bonding materials. For instance, solder paste or conductive adhesive is coated on a semiconductor chip, and then a copper clip is placed on the solder paste or conductive adhesive, and thus forming a bonding line. Because the copper clip exerts downward pressure on the solder paste or the conductive adhesive, a thickness distribution of the bonding line may be uneven and may cause the copper clip to tilt relative to the semiconductor chip. In other words, a bottom surface of the copper clip (i.e., a surface of the copper clip facing the semiconductor chip) is not parallel to a top surface of the semiconductor chip, resulting in poor assembly consistency and poor reliability. In some applications, it is necessary to integrate the copper clips with package pins of the semiconductor chip to further increase the reliability and heat dissipation capabilities of a semiconductor chip unit. An integrated design of the package pins allows a source current of the semiconductor chip to directly connect to an external circuit. However, a relative assembly accuracy of the copper clip, the top surface of the semiconductor chip, and a copper frame thereof has a decisive impact on an overall package dimension of the semiconductor chip unit. Therefore, it is necessary to specifically design a positional coordination between the copper clip, the semiconductor chip, and the copper frame, so that the relative assembly accuracy thereof is effectively guaranteed. As mentioned above, if a proper design is not carried out to ensure the relative assembly accuracy between the copper clip, the semiconductor chip, and the copper frame, an accuracy of the package dimension of the semiconductor chip unit is not guaranteed, thus affecting product yield, reliability, and service life thereof.

Moreover, in some current applications, a single semiconductor chip unit occupies a large area on the copper frame, while there are a plurality of semiconductor chip units disposed on the same copper frame, so a density of the semiconductor chip units is generally low. Each of the semiconductor chip units is individually positioned and isolated on the copper frame, which results in the copper frame having a large area of spacing between the semiconductor chip units and results in an insufficient density of the semiconductor chip units on the copper frame.

### SUMMARY

In view of deficiencies in the prior art, a first purpose of the present disclosure is to provide a metal clip assembly with a high-density integrated design and easy to ensure accuracy of use. The metal clip assembly comprises metal clip units. The metal clip units comprise connectors, pins, and at least one group of spatial positioning grooves. Each group of spatial positioning grooves comprises at least two X-direction positioning grooves and at least two Y-direction positioning grooves. At least two of the metal clip units share one group of the at least one group of spatial positioning grooves.

Furthermore, the metal clip assembly comprises metal clip unit pairs. Each of the metal clip unit pairs comprises two metal clip units. The two metal clip units thereof share a corresponding group of spatial positioning grooves thereof. In each of the metal clip unit pairs, the pins of the two metal clip units thereof are connected and connectors thereof are away from each other.

Furthermore, the metal clip unit pairs are disposed along a width direction. Each two adjacent metal clip units are fixedly connected with each other and shares the corresponding group of spatial positioning grooves thereof to form the metal clip assembly. Alternatively, the metal clip units are disposed and connected along the width direction and share the at least one group of spatial positioning grooves to form the metal clip assembly.

Furthermore, the connectors comprise copper clips.

A second purpose of the present disclosure is to provide a semiconductor device assembly. The semiconductor device assembly comprises a metal frame and metal clip assemblies. The metal frame comprises chip stages and chips. The chips are respectively disposed on the chip stages. Each of the connectors is disposed above a corresponding chip. Each of the connectors is configured to connect the corresponding chip and corresponding pins. X-direction positioning pins and Y-direction positioning pins are disposed on the metal frame. The X-direction positioning pins are respectively connected with the X-direction positioning grooves and the Y-direction positioning pins are respectively connected with the Y-direction positioning grooves.

Furthermore, positioning bumps are disposed on the metal frame. A quantity of the positioning bumps is not less than a quantity of the metal clip assemblies. Each of the positioning bumps is disposed below a corresponding metal clip assembly and is configured to position the corresponding metal clip assembly along a Z direction. The metal clip units in each of the metal clip assemblies share a corresponding positioning bump. Encapsulation layers are disposed above the chip stages. The chips and the connectors are disposed in the encapsulation layers.

A third purpose of the present disclosure is to provide a preparation method of the semiconductor device assembly. The preparation method comprises steps A-C.

The step A comprises mounting chips on a metal frame.

The step B comprises mounting connectors and pins of metal clip assemblies of the semiconductor device assembly with the chips and the metal frame; connecting X-direction positioning pins respectively with the X-direction positioning grooves and connecting Y-direction positioning pins respectively with the Y-direction positioning grooves.

The step C comprises performing plastic packaging on the chips and the connectors respectively disposed on the chip stages to obtain encapsulation layers.

Furthermore, the step A comprises steps a1 and a2. The step a1 comprises chip preparation. Specifically, checking whether there is a film on a back surface of a wafer, if yes, performing wafer cutting, and if no, the film is adhered to the back surface the wafer and then performing the wafer cutting on the wafer to obtain the chips.

The step a2 comprises chip mounting. Specifically, coating silver paste or solder paste on the chip stages, placing the chips on the silver paste or the solder paste. When the silver paste is coated on the chip stages, baking to fix the chips through an oven when the solder paste is coated on the chip stages. When the solder paste is pasted on the chip stages, performing reflow soldering separately or performing the reflow soldering in the step B.

The step B comprises steps b1 and b2. the step b1 comprises coating the solder paste on the chips and predetermined areas of the metal frame, placing the pins and the connectors on the solder paste, positioning the metal frame by snapping X-direction positioning pins respectively in X-direction positioning grooves and snapping Y-direction positioning pins respectively in Y-direction positioning grooves, and when positioning bumps are disposed on the metal frame, enabling the positioning bumps respectively being abut against lower surfaces of the metal clip assemblies.

The step b2 comprises performing the reflow soldering in a reflow oven to melt the solder paste for eutectic soldering. The solder paste is coated between the chips and the metal frame or the solder paste is coated between the chips and the metal clip assemblies.

The step C comprises steps c1- c2.

The step c1 comprises cleaning a semi-finished product obtained in the step B by soaking with an ultrasonic chemical reagent or cleaning the semi-finished product obtained in the step B by spraying a chemical reagent.

The step c2 comprises performing plastic packaging on the chips and the connectors to obtain encapsulation layers, or, integrally packaging and curing the chips and the connectors along a width direction of metal clip units to obtain the encapsulation layers.

A fourth purpose of the present disclosure is to provide a use of the semiconductor device assembly. The use comprises a step D of cutting the semiconductor device assembly.

Furthermore, the step D comprises steps d0-d2.

The step d0 comprises removing flash left in a plastic packaging process and/or performing an electroplating operation. The electroplating operation comprises removing impurities and organic matters on a surface of the metal frame, slightly corroding the surface of the metal frame, plating a tin layer on the surface of the metal frame, cleaning to remove chemical residues, and baking the semiconductor device assembly.

The step d1 comprises cutting off connecting ribs of the semiconductor device assembly. If the encapsulation layers are obtained by curing the chips and the connectors along a width direction of metal clip units, the use further comprises the step d2 of cutting the encapsulation layers to obtain single products.

The use further comprises a step E. The step E is performed between the step d1 and the step d2, or, the step E is performed after the step d2. The step E comprises bending each of the pins to form a predetermined shape.

After the step E, the use further comprises a step F. The step F comprises testing the single products to screen out appearance defective products and performed defective products according to an electrical performance requirement specification; selecting carrier tapes, the cover tapes, and packaging cartons for qualified products to package the qualified products; respectively attaching labels each containing complete product information to the packaging cartons; and storing the packaging cartons in a warehouse with a temperature and a humidity meeting a predetermined requirement and waiting for shipment.

Compared with the prior art, the present disclosure has following characteristics.

The metal clip assembly is integrated with the metal clip units, and the metal clip units comprise the connectors, the pins, and the at least one group of spatial positioning grooves. By sharing the at least one group of spatial positioning grooves between the metal clip units, a spatial structure of the metal clip assembly is simplified, and at the same time, it facilitates convenient positioning on the metal frame during subsequent use.

The semiconductor device assembly comprises the metal frame and the metal clip assemblies. Positions of the metal clip assemblies are accurately positioned in a horizontal direction of the metal frame through accurate cooperation between the X-direction positioning grooves and the X-direction positioning pins, and the accurate cooperation between the Y-direction positioning grooves and the Y-direction positioning pins. Further, positions of the metal clip assemblies in a height direction of the metal frame is accurately positioned by configuration of the positioning bumps. Furthermore, the semiconductor device assembly uses a surface tension of the solder paste when the solder paste is melt to complete an automatic alignment of the metal clip assemblies on the metal frame with considerable accuracy.

In the preparation method of the semiconductor device assembly, the chips and the metal clip assemblies are respectively positioned and mounted on the metal frame. A layout of the semiconductor device assembly is first designed and then the semiconductor device assembly is manufactured, integrally plastic packaged, and then cut to form the single products, thereby reducing production costs.

In the use of the semiconductor device assembly, the semiconductor device assembly is separated by cutting. Optionally, the semiconductor device assembly is separated by double-sided cutting, which reduces stress of mechanical stamping and cutting, thereby improving reliability of the single products. The pins of the single products that are exposed outside are allowed to be processed through cutting the connecting ribs, bending, and cutting separation technology, thereby ensuring that the pins meets the design requirements for specific occasions.

### BRIEF DESCRIPTION OF DRAWINGS

FIG. 1 is an exploded perspective schematic diagram of a semiconductor device assembly according to Embodiment 2 of the present disclosure.
FIG. 2 is a perspective schematic diagram of the semiconductor device assembly according to Embodiment 2 of the present disclosure.
FIG. 3 is an exploded perspective schematic diagram of the semiconductor device assembly according to Embodiment 4 of the present disclosure.
FIG. 4 is a perspective schematic diagram of the semiconductor device assembly according to Embodiment 4 of the present disclosure.
FIG. 5 is an exploded perspective schematic diagram of the semiconductor device assembly according to Embodiment 6 of the present disclosure.
FIG. 6 is a perspective schematic diagram of the semiconductor device assembly according to Embodiment 6 of the present disclosure.
FIG. 7 is a flow chart of a preparation method of the semiconductor device assembly according to Embodiment 9 of the present disclosure.
FIG. 8 is another flow chart of the preparation method of the semiconductor device assembly according to Embodiment 9 of the present disclosure.
FIG. 9 is a flow chart of a use of the semiconductor device assembly according to Embodiment 10 of the present disclosure.
FIG. 10 is another flow chart of the use of the semiconductor device assembly according to Embodiment 10 of the present disclosure.

Reference numerals: 1-metal clip assembly; 11-connector; 12-pin; 13-spatial positioning groove; 131-X-direction positioning grooves; 132-Y-direction positioning grooves; 2-metal frame; 21-chip stage; 22-chip; 23-X direction positioning pin; 24-Y-direction positioning pins; 25-positioning bump; 26-encapsulation layer; 3-mounting chips on a metal frame; 301-chip preparation; 302-chip mounting; 4-mounting connectors and pins of metal clip assemblies of the semiconductor device assembly with the chips and the metal frame; connecting X-direction positioning pins respectively with the X-direction positioning grooves and connecting Y-direction positioning pins respectively with the Y-direction positioning grooves; 401-coating the solder paste on the chips and predetermined areas of the metal frame; placing the pins and the connectors on the solder paste for positioning; 5-performing plastic packaging on the chips and the connectors respectively disposed on the chip stages to obtain encapsulation layers. 501-chemical cleaning; 502-plastic packaging; 6-utting the semiconductor device assembly; 601-removing flash left in a plastic packaging process and/or performing an electroplating operation; 602-cutting off connecting ribs of the semiconductor device assembly; 603-cutting the encapsulation layers to obtain single products; 7-bending each of the pins to form a predetermined shape; 8-testing the single products to screen out appearance defective products and performed defective products according to an electrical performance requirement specification; selecting carrier tapes; the cover tapes; and packaging cartons for qualified products to package the qualified products; respectively attaching labels each containing complete product information to the packaging cartons; and storing the packaging cartons in a warehouse with a temperature and a humidity meeting a predetermined requirement and waiting for shipment.

### DETAILED DESCRIPTION

The following embodiments are used to help those skilled in the art further understand the present disclosure, but do not limit the present disclosure in any form. In the following description, in order to clearly demonstrate a structure and a working mode of the present disclosure, many directional words are used for description, such as "front", "back", "left", "right", "outside", "inside"", "outward", "inward", "up", "down", and other words are to be understood as convenient terms and should not be understood as limiting terms. The "far" and "closer" in "far section", "far end", "close section", and "close end" in this article are relative to a position of an operator. That is, "close" is to depict that a position thereof is close to the operator, and "far" is to depict that a position thereof is far away from the operator.

Those skilled in the art can make changes and improvements without departing from the concept of the present disclosure, all of which should fall within the protection scope of the present disclosure. The endpoints and any values of ranges disclosed herein are not limited to the precise range or value, which should be understood to include values close to the ranges or values. For a numerical range, one or more new numerical ranges may be obtained by combining endpoint values of various ranges, endpoint values of various ranges, separate point values, and separate point values, which should be considered as specifically disclosed by the present disclosure. The present disclosure is described in detail below with reference to specific embodiments.

### Embodiment 1

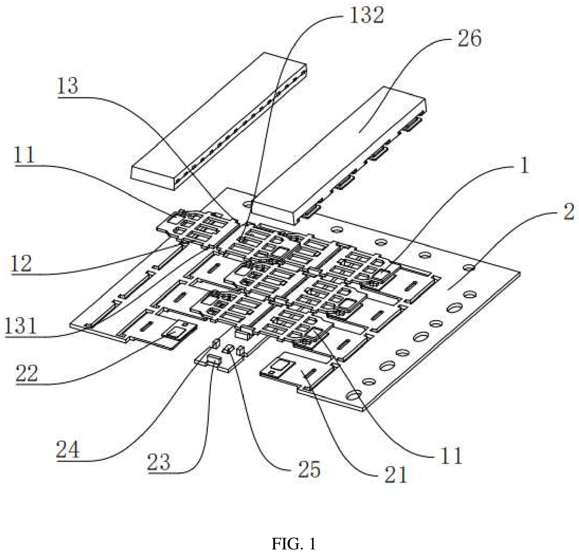

As shown in FIG. 1, the embodiment provides a metal clip assembly 1. The metal clip assembly 1 comprises two metal clip units. The two metal clip units comprise connectors 11, pins 12, and one group of spatial positioning grooves 13. The one group of spatial positioning grooves 13 comprises two X-direction positioning grooves 131 and two Y-direction positioning grooves 132. The two metal clip units share the one group of spatial positioning grooves 13. In the embodiment, the connectors 11 are copper clips.

### Embodiment 2

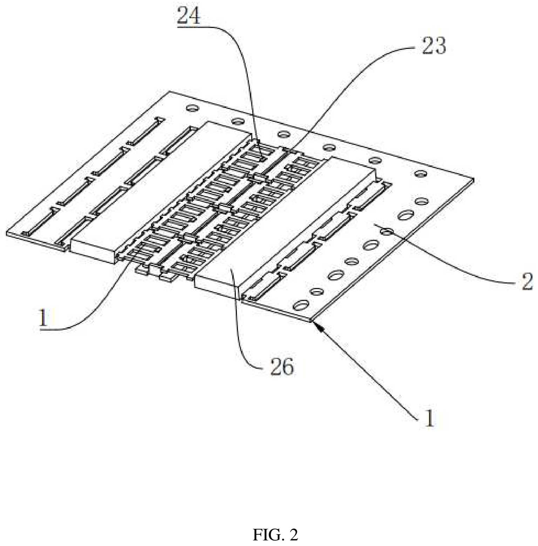

As shown in FIGS. 1 and 2, the embodiment provides a semiconductor device assembly. The semiconductor device assembly comprises a metal frame 2 and four metal clip assemblies 1 of the Embodiment 1. The metal frame comprises eight chip stages 21 and eight chips 22. The chips 22 are respectively disposed on the chip stages 21. Each of the connectors 11 is disposed above a corresponding chip 22. Each of the connectors 11 is configured to connect the corresponding chip 22 and corresponding pins 12.

X-direction positioning pins 23 and Y-direction positioning pins 24 are disposed on the metal frame 2. The X-direction positioning pins 23 are respectively connected with the X-direction positioning grooves 131 and the Y-direction positioning pins 24 are respectively connected with the Y-direction positioning grooves 132.

In one optional embodiment, four positioning bumps 25 are disposed on the metal frame 2. Each of the positioning bumps 25 are disposed below a center of a corresponding metal clip assembly 1.

In another optional embodiment, encapsulation layers 26 are disposed above the chip stages 21. The chips 22 and the connectors 11 are disposed in the encapsulation layers 26.

### Embodiment 3

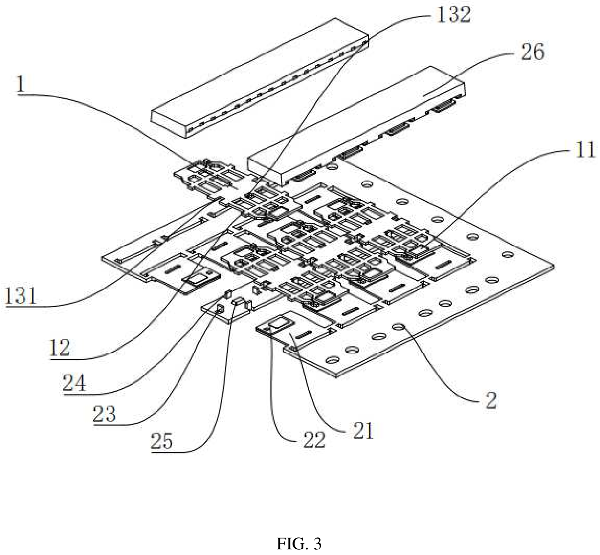

As shown in FIG. 3, the embodiment provides a metal clip assembly 1. The metal clip assembly 1 comprises two metal clip units. The two metal clip units comprise connectors 11, pins 12, and one group of spatial positioning grooves 13. A difference from Embodiment 1 is that in the embodiment, the pins 12 of the two metal clip units thereof are connected and the two connectors 11 thereof are away from each other.

The one group of spatial positioning grooves 13 comprises two X-direction positioning grooves 131 and two Y-direction positioning grooves 132. The two metal clip units share the one group of spatial positioning grooves 13.

### Embodiment 4

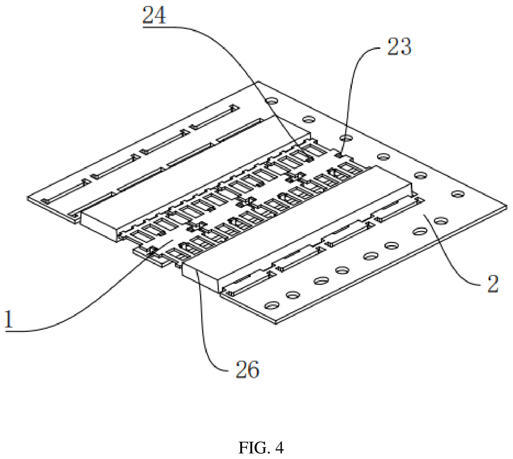

As shown in FIGS. 3 and 4, the embodiment provides a semiconductor device assembly. The semiconductor device assembly comprises a metal frame 2 and four metal clip assemblies 1 of the Embodiment 3. The metal frame comprises eight chip stages 21 and eight chips 22. The chips 22 are respectively disposed on the chip stages 21. Each of the connectors 11 is disposed above a corresponding chip 22. Each of the connectors 11 is configured to connect the corresponding chip 22 and corresponding pins 12.

Eight X-direction positioning pins 23 and eight Y-direction positioning pins 24 are disposed on the metal frame 2. The X-direction positioning pins 23 are respectively connected with the X-direction positioning grooves 131 and the Y-direction positioning pins 24 are respectively connected with the Y-direction positioning grooves 132.

In one optional embodiment, four positioning bumps 25 are disposed on the metal frame 2. Each of the positioning bumps 25 are disposed below a center of a corresponding metal clip assembly 1.

In another optional embodiment, encapsulation layers 26 are disposed above the chip stages 21. The chips 22 and the connectors 11 are disposed in the encapsulation layers 26.

### Embodiment 5

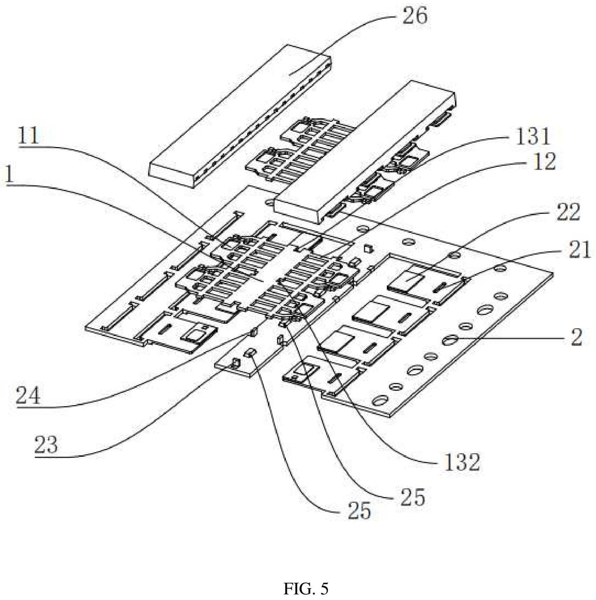

As shown in FIG. 5, the embodiment provides a metal clip assembly 1. The metal clip assembly 1 comprises four metal clip units. The four metal clip units comprise connectors 11, pins 12, and groups of spatial positioning grooves 13.

The four metal clip units are in pairs to form two metal clip unit pairs, and the two pins 12 of each of the metal clip unit pairs are connected. The two connectors 11 of each of the metal clip unit pairs are away from each other. The two metal clip unit pairs are connected in a width direction thereof.

Each group of spatial positioning grooves 13 comprises two X-direction positioning grooves 131 and two Y-direction positioning grooves 132. Each of the metal clip unit pairs share a corresponding group of spatial positioning grooves 13.

### Embodiment 6

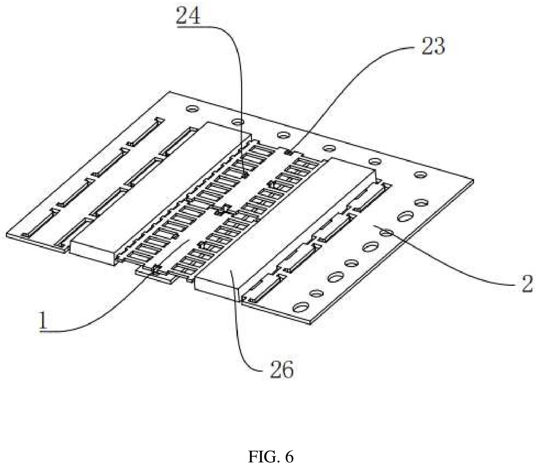

As shown in FIGS. 5 and 6, the embodiment provides a semiconductor device assembly. The semiconductor device assembly comprises a metal frame 2 and two metal clip assemblies 1 of the Embodiment 5. The metal frame comprises eight chip stages 21 and eight chips 22. The chips 22 are respectively disposed on the chip stages 21. Each of the connectors 11 is disposed above a corresponding chip 22. Each of the connectors 11 is configured to connect the corresponding chip 22 and corresponding pins 12.

Four X-direction positioning pins 23 and four Y-direction positioning pins 24 are disposed on the metal frame 2. The X-direction positioning pins 23 are respectively connected with the X-direction positioning grooves 131 and the Y-direction positioning pins 24 are respectively connected with the Y-direction positioning grooves 132.

In one optional embodiment, four positioning bumps 25 are disposed on the metal frame 2. Each two of the positioning bumps 25 are disposed below a corresponding metal clip assembly 1 having a larger dimension, which facilitates the metal clip assemblies 1 to be kept horizontal.

In another optional embodiment, encapsulation layers 26 are disposed above the chip stages 21. The chips 22 and the connectors 11 are disposed in the encapsulation layers 26.

### Embodiment 7

The embodiment provides a metal clip assembly 1 9not shown in the drawings). The metal clip assembly comprises four metal clip units. The four metal clip units comprise connectors, pins, and groups of spatial positioning grooves. A difference from Embodiment 1 is that the four metal clip units are disposed and connected along a width direction thereof.

Each group of spatial positioning grooves comprises two X-direction positioning grooves and two Y-direction positioning grooves. Each two adjacent metal clip units share a corresponding group of spatial positioning grooves 13.

### Embodiment 8

The embodiment provides a semiconductor device assembly (not shown). The semiconductor device assembly comprises a metal frame and two metal clip assemblies 1 of the Embodiment 7. The metal frame comprises eight chip stages and eight chips. The chips are respectively disposed on the chip stages. Each of the connectors is disposed above a corresponding chip. Each of the connectors is configured to connect the corresponding chip and corresponding pins.

Four X-direction positioning pins and four Y-direction positioning pins are disposed on the metal frame. The X-direction positioning pins are respectively connected with the X-direction positioning grooves and the Y-direction positioning pins are respectively connected with the Y-direction positioning grooves.

In one optional embodiment, four positioning bumps 25 are disposed on the metal frame 2. Each two of the positioning bumps 25 are disposed below a corresponding metal clip assembly 1 having a larger dimension, which facilitates the metal clip assemblies 1 to be kept horizontal.

In another optional embodiment, encapsulation layers 26 are disposed above the chip stages 21. The chips 22 and the connectors 11 are disposed in the encapsulation layers 26.

In the embodiment, a redundant frame structure configured to carry and isolate single products of the metal frame is simplified through a layout thereof, thereby increasing a density of the single products on one metal frame, and significantly increasing the density of the single products on one metal frame 2 based on a conventional packaging density. A product density increase ratio on one metal frame increases by at least 30%. Positions of the metal clip assemblies are accurately positioned in a horizontal direction of the metal frame through accurate cooperation between the X-direction positioning grooves and the X-direction positioning pins, and the accurate cooperation between the Y-direction positioning grooves and the Y-direction positioning pins. Further, positions of the metal clip assemblies in a height direction of the metal frame is accurately positioned by configuration of the positioning bumps. Furthermore, the semiconductor device assembly uses a surface tension of the solder paste when the solder paste is melt to complete an automatic alignment of the metal clip assemblies on the metal frame with considerable accuracy.

### Embodiment 9

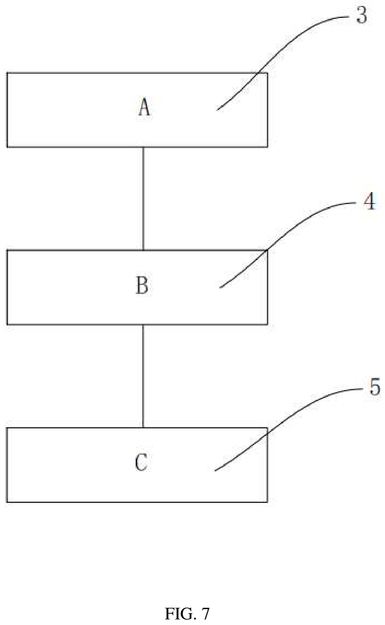

As shown in FIG. 7, the embodiment provides a preparation method of the semiconductor device assembly shown in FIG. 1. The preparation method comprises steps A-C.

The step A comprises mounting chips 22 on the metal frame 2.

The step B comprises mounting the connectors 11 and the pins 12 of the metal clip assemblies 1 of the semiconductor device assembly with the chips 22 and the metal frame 2; and connecting the X-direction positioning pins 23 respectively with the X-direction positioning grooves 131 and connecting the Y-direction positioning pins 24 respectively with the Y-direction positioning grooves 132.

The step C comprises performing plastic packaging on the chips 22 and the connectors 11 respectively disposed on the chip stages 21 to obtain the encapsulation layers 26.

In one optional embodiment, the step A comprises steps a1 and a2. The step a1 comprises chip preparation. Specifically, checking whether there is a film on a back surface a wafer, if yes, performing wafer cutting, and if no, the film is adhered to the back surface of the wafer and then performing the wafer cutting on the wafer to obtain the chips 22. If the chips 22 are prepared in advance, the step a1 is omitted.

The step a2 comprises chip mounting. Specifically, coating silver paste or solder paste on predetermined areas (i.e., the chip stages 21) of the metal frame 2, sucking the chips 22 and placing the chips 22 on the silver paste or the solder paste by a machine.

In one embodiment, when the silver paste is coated on the chip stages, baking to fix the chips through an oven.

In one alternative embodiment, when the solder paste is pasted on the chip stages, performing reflow soldering separately or performing the reflow soldering in the step B.

In one embodiment, the step B comprises steps b1 and b2. The step b1 comprises coating the solder paste on the chips 22 and the predetermined areas of the metal frame 2, placing the pins 12 and the connectors 11 on the solder paste, positioning the metal frame 2 by snapping the X-direction positioning pins 23 respectively in the X-direction positioning grooves 131 and snapping the Y-direction positioning pins 24 respectively in the Y-direction positioning grooves 132, and when the positioning bumps 25 are disposed on the metal frame 2, enabling the positioning bumps 25 respectively being abut against lower surfaces of the metal clip assemblies 1.

The step b2 comprises performing the reflow soldering in a reflow oven to melt the solder paste for eutectic soldering. The solder paste is coated between the chips 22 and the metal frame 2 or the solder paste is coated between the chips 22 and the metal clip assemblies 1.

In one embodiment, the step C comprises steps c1- c2.

The step c1 comprises cleaning a semi-finished product obtained in the step B by soaking with an ultrasonic chemical reagent or cleaning the semi-finished product obtained in the step B by spraying a chemical reagent. The step c1 is conductive to reducing a risk of product stratification in subsequent processes.

The step c2 comprises integrally packaging and curing the chips 22 and the connectors 11 along a width direction of metal clip units to obtain the encapsulation layers 26. Thus, the semiconductor device assembly shown in FIG. 1 is obtained.

In the preparation method of the present disclosure, through a layout and a preparation of the semiconductor device assembly and through cutting and parting after plastic packaging, production costs are reduced.

### Embodiment 10

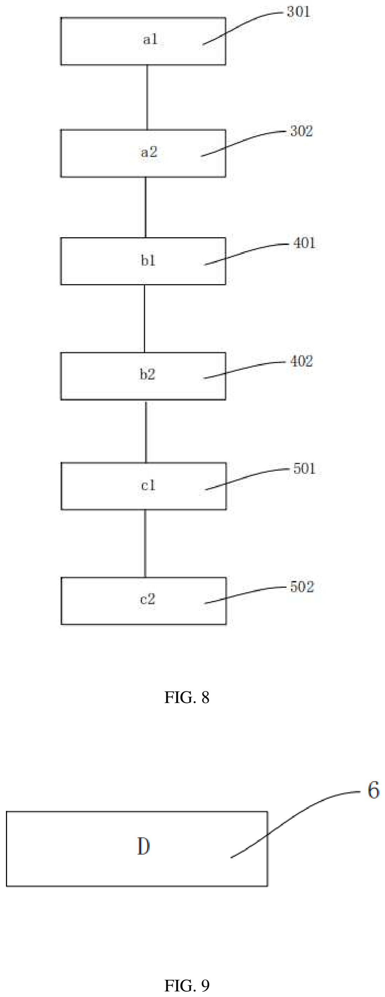

As shown in FIG. 9, the embodiment provides a use of the semiconductor device assembly. The use comprises a step D of cutting the semiconductor device assembly.

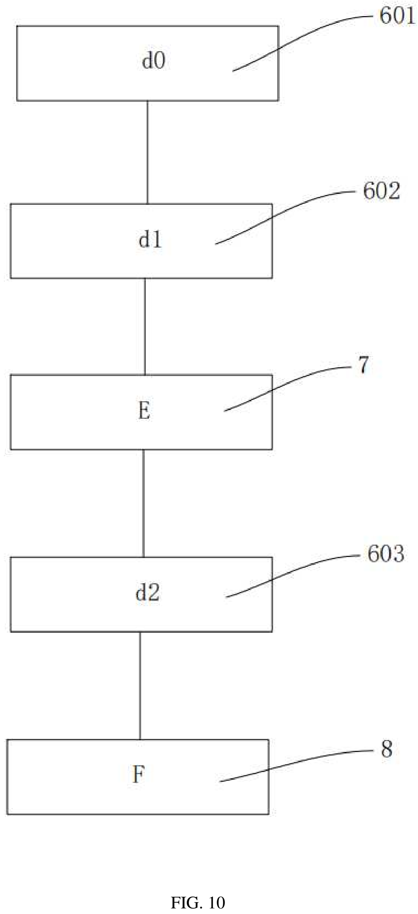

As shown in FIG. 10, the step D comprises steps d0-d2.

The step d0 comprises removing flash left in a plastic packaging process and/or performing an electroplating operation.

The electroplating operation comprises removing impurities and organic matters on a surface of the metal frame, slightly corroding the surface of the metal frame, plating a tin layer on the surface of the metal frame, cleaning to remove chemical residues, and baking the semiconductor device assembly.

The step d1 comprises cutting off connecting ribs of the semiconductor device assembly.

The use further comprises a step E. The step E comprises bending each of the pins 12 to form a predetermined shape. The step E is performed between the step d1 and the step d2, or, the step E is performed after the step d2. In the embodiment, the step E is performed between the steps d1 and d2, making bending and shaping of the pins 12 more convenient.

The step d2 comprise cutting the encapsulation layers 26 to obtain single products. Optionally, the encapsulation layers 26 are cut from two sides to separate the single products from the encapsulation layers 26.

After the step E, the use further comprises a step F. The step F comprises testing the single products to screen out appearance defective products and performed defective products according to an electrical performance requirement specification; selecting carrier tapes, the cover tapes, and packaging cartons for qualified products to package the qualified products; respectively attaching labels each containing complete product information to the packaging cartons; and storing the packaging cartons in a warehouse with a temperature and a humidity meeting a predetermined requirement and waiting for shipment.

In the use of the semiconductor device assembly, the semiconductor device assembly is separated by cutting. Optionally, the semiconductor device assembly is separated by double-sided cutting, which reduces stress of mechanical stamping and cutting, thereby improving reliability of the single products. The pins 12 of the single products that are exposed outside are allowed to be processed through cutting the connecting ribs, bending, and cutting separation technology, thereby ensuring that the pins meets the design requirements for specific occasions.

Specific embodiments of the present disclosure are described above. It should be understood that the present disclosure is not limited to the specific embodiments described above, and those skilled in the art can make various changes or modifications within the scope of the claims, which does not affect the essential content of the present disclosure. In the case of no conflict, the embodiments of the present disclosure and the features in the embodiments may be combined with each other.

## Claims

1. A metal clip assembly, comprising: metal clip units;
wherein the metal clip units comprise connectors (11), pins (12), and at least one group of spatial positioning grooves (13); each group of spatial positioning grooves (13) comprises at least two X-direction positioning grooves (131) and at least two Y-direction positioning grooves (132); at least two of the metal clip units share one group of the at least one group of spatial positioning grooves (13).

2. The metal clip assembly of claim 1, wherein the metal clip assembly comprises metal clip unit pairs; each of the metal clip unit pairs comprises two metal clip units; the two metal clip units thereof share a corresponding group of spatial positioning grooves (13) thereof; in each of the metal clip unit pairs, the pins (12) of the two metal clip units thereof are connected and the connectors (11) thereof are away from each other.

3. The metal clip assembly of claim 2, wherein the metal clip unit pairs are disposed along a width direction thereof; each two adjacent metal clip units are fixedly connected with each other and shares the corresponding group of spatial positioning grooves (13) thereof to form the metal clip assembly (1); or
the metal clip units are disposed and connected along the width direction and share the at least one group of spatial positioning grooves (13) to form the metal clip assembly (1).

4. The metal clip assembly of claim 1, wherein the connectors (11) comprise copper clips.

5. A semiconductor device assembly, comprising: a metal frame (2) and metal clip assemblies (1) of any claims 1-4;
wherein the metal frame (2) comprises chip stages (21) and chips (22); the chips (22) are respectively disposed on the chip stages (21); each of the connectors (11) is disposed above a corresponding chip (22); each of the connectors (11) is configured to connect the corresponding chip (22) and corresponding pins (12); X-direction positioning pins (23) and Y-direction positioning pins (24) are disposed on the metal frame (2); the X-direction positioning pins (23) are respectively connected with the X-direction positioning grooves (131) and the Y-direction positioning pins (24) are respectively connected with the Y-direction positioning grooves (132).

6. The semiconductor device assembly of claim 5, wherein positioning bumps (25) are disposed on the metal frame (2); a quantity of the positioning bumps (25) is not less than a quantity of the metal clip assemblies (1); each of the positioning bumps (25) is disposed below a corresponding metal clip assembly and is configured to position the corresponding metal clip assembly along a Z direction; the metal clip units in each of the metal clip assemblies (1) share a corresponding positioning bump; encapsulation layers (26) are disposed above the chip stages (21); the chips (22) and the connectors (11) are disposed in the encapsulation layers (26).

7. A preparation method of a semiconductor device assembly, comprising:
a step A: mounting chips (22) on a metal frame (2);
a step B: mounting connectors (11) and pins (12) of metal clip assemblies (1) of the semiconductor device assembly with the chips (22) and the metal frame (2); connecting X-direction positioning pins (23) respectively with the X-direction positioning grooves (131) and connecting Y-direction positioning pins (24) respectively with the Y-direction positioning grooves (132); and
a step C: performing plastic packaging on the chips and the connectors (11) respectively disposed on the chip stages (21) to obtain encapsulation layers (26).

8. The preparation method of claim 7, wherein the step A comprises
a step a1: chip preparation; checking whether there is a film on a back surface of a wafer, if yes, performing wafer cutting; and if no, the film is adhered to the back surface of the wafer and then performing the wafer cutting on the wafer to obtain the chips (22); and
a step a2: chip mounting: coating silver paste or solder paste on the chip stages (21), placing the chips (22) on the silver paste or the solder paste; when the silver paste is coated on the chip stages (21), baking to fix the chips (22) through an oven when the solder paste is coated on the chip stages (21); when the solder paste is coated on the chip stages (21), performing reflow soldering separately or performing the reflow soldering in the step B;
wherein the step B comprises:
a step b1: coating the solder paste on the chips (22) and the chip stages (21) of the metal frame (2), placing the pins (12) and the connectors (11) on the solder paste, positioning the metal frame (2) by snapping X-direction positioning pins (23) respectively in X-direction positioning grooves (131) and snapping Y-direction positioning pins (24) respectively in Y-direction positioning grooves (132), and when positioning bumps (25) are disposed on the metal frame (2), enabling the positioning bumps (25) respectively being abut against lower surfaces of the metal clip assemblies (1); and
a step b2: performing the reflow soldering in a reflow oven to melt the solder paste for eutectic soldering; wherein the solder paste is coated between the chips (22) and the metal frame (2) or the solder paste is coated between the chips (22) and the metal clip assemblies (1);
wherein the step C comprises:
a step c1: cleaning a semi-finished product obtained in the step B by soaking with an ultrasonic chemical reagent or cleaning the semi-finished product obtained in the step B by spraying a chemical reagent; and
a step c2: performing plastic packaging on the chips (22) and the connectors (11) to obtain encapsulation layers (26), or, integrally packaging and curing the chips (22) and the connectors (11) along a width direction of metal clip units to obtain the encapsulation layers (26).

9. A use of a semiconductor device assembly, comprising:
a step D: cutting the semiconductor device assembly of claim 5.

10. The use of claim 9, wherein the step D comprises:
a step d0: removing flash left in a plastic packaging process and/or performing an electroplating operation; wherein the electroplating operation comprises removing impurities and organic matters on a surface of the metal frame (2), slightly corroding the surface of the metal frame (2), plating a tin layer on the surface of the metal frame (2); cleaning to remove chemical residues, and baking the semiconductor device assembly;
a step d1: cutting off connecting ribs of the semiconductor device assembly; if encapsulation layers (26) are obtained by curing the chips (22) and the connectors (11) along a width direction of metal clip units, the use further comprises:
a step d2: cutting the encapsulation layers (26) to obtain single products;
wherein the use further comprises a step E; the step E is performed between the step d1 and the step d2, or, the step E is performed after the step d2; the step E comprises bending each of the pins (12) to form a predetermined shape;
wherein after the step E, the use further comprises a step F; the step F comprises:
testing the single products to screen out appearance defective products and performed defective products according to an electrical performance requirement specification;
selecting carrier tapes, the cover tapes, and packaging cartons for qualified products to package the qualified products;
respectively attaching labels each containing complete product information to the packaging cartons; and
storing the packaging cartons in a warehouse with a temperature and a humidity meeting a predetermined requirement and waiting for shipment.
